**Europäisches Patentamt**

**European Patent Office**

**Office européen des brevets**

(19)

(11) Veröffentlichungsnummer : **0 011 705**
**B1**

(12) **EUROPÄISCHE PATENTSCHRIFT**

(45) Veröffentlichungstag der Patentschrift :
28.04.82

(21) Anmeldenummer : **79104040.5**

(22) Anmeldetag : **18.10.79**

(51) Int. Cl.³ : **H 03 F  3/187**, H 03 F  3/45,
H 04 M  1/60

(54) **Mikrofonverstärker, insbesondere für Fernsprechanlagen.**

(30) Priorität : **23.11.78 DE 2850792**

(43) Veröffentlichungstag der Anmeldung :
**11.06.80 (Patentblatt 80/12)**

(45) Bekanntmachung des Hinweises auf die Patenterteilung : **28.04.82 Patentblatt 82/17**

(84) Benannte Vertragsstaaten :
**AT BE CH FR GB IT SE**

(56) Entgegenhaltungen :
**FR - A - 2 176 745**
**US - A - 3 979 689**
**US - A - 4 034 306**
**US - A - 4 101 842**

(73) Patentinhaber : **SIEMENS AKTIENGESELLSCHAFT**
**Berlin und München**
**Postfach 22 02 61**
**D-8000 München 22 (DE)**

(72) Erfinder : **Krämer, Horst, Dipl.-Ing.**
**Tucholskystrasse 16**
**D-8000 München 83 (DE)**

Imprimerie Jouve, 18, rue St-Denis, 75001 Paris, France

Mikrofonverstärker, insbesondere für Fernsprechanlagen

Bekanntlich werden auch in Fernsprechanlagen Mikrofonverstärker verwendet, und zwar wenn beispielsweise piezoelektrische Mikrofone vorgesehen sind. Es sind auch bereits verschiedene Varianten solcher Mikrofonverstärker bekannt. Bei solchen Mikrofonverstärkern ist das Wechselstrom-Ausgangssignal dem Speisestrom überlagert (siehe Siemens-Datenbuch 1974/75, Band 2, « Lineare Schaltungen », Seiten 213 bis 215 ; DE-A-17 62 924, DE-A-18 08 247). Zu solchen Mikrofonverstärkern gehört als Eingangsstufe ein zwischen seiner Eingangsstufe und seiner Ausgangsstufe gleichstromgekoppelter Mikrofonverstärker, dessen Wechselstrom-Ausgangssignal dem Speisestrom überlagert ist und zu dem als Eingangsstufe für das entsprechende Wechselsignal ein Differenzverstärker mit zwei Transistoren und mit Widerstandsstabilisierung im Emitterkreis, als Ausgangsstufe für das verstärkte Wechselsignal, also für das Wechselstrom-Ausgangssignal, ein als gesteuerte Spannungsquelle arbeitender Darlington-Verstärker, ein zwischen der Ausgangsstufe und der Eingangsstufe eingefügtes Spannungsgegenkopplungsnetzwerk und eine Referenzspannungsquelle bzw. Referenzstromquelle zur Stabilisierung des Arbeitspunktes des Differenzverstärkers gehören.

Die Erfindung geht nun von der Aufgabe aus, die Betriebseigenschaften solcher Mikrofonverstärker zu verbessern. Die Verbesserung betrifft insbesondere Maßnahmen, die die Stabilität der Arbeitspunkte der zugehörigen Transistoren über einen besonders großen Bereich des Speisestroms sicherstellen. Dies ist besonders wichtig für Mikrofonverstärker, die zu Fernsprechanlagen gehören, da bei Fernsprechanlagen der Speisegleichstrom bekanntlich sehr unterschiedlich sein kann. Durch weitere Ausgestaltung wird sich ergeben, daß der Mikrofonverstärker einerseits mit sehr geringem Speisestrom arbeiten kann und andererseits eine hohe Aussteuerfähigkeit hat.

Gemäß der Erfindung ist ein derartiger Mikrofonverstärker dadurch gekennzeichnet, daß der Differenzverstärker das Wechselsignal über eine zwei Zweige aufweisende, symmetrisch geschaltete Transistorkoppelstufe und über einen hochverstärkenden Zwischenverstärker zum Darlington-Verstärker weiterleitet, und daß zur Stabilisierung der Arbeitspunkte der Eingangsstufe des Differenzverstärkers, der Transistorkoppelstufe und des Zwischenverstärkers mittels Stromspiegelschaltungen die Eingangsstufe des Differenzverstärkers und die Transistorkoppelstufe stromsymmetrisch eingestellt sind, wobei eine der Stromspiegelschaltungen einen Stromzweig hat, über den der gemeinsame Emitterkreis der Eingangsstufe geführt ist und wobei eine andere, erste Stromspiegelschaltung zwei Stromzweige hat, über die die Zweige der Transistorkoppelstuffe geführt sind.

Hierbei kommen Stromspiegelschaltungen infrage, wie sie an sich bekannt sind (siehe DOS 24 40 023, 26 42 874 ; Philips Technische Rundschau 1971/72, Nr. 1, Seiten 4 bis 8 ; Regelungstechnik, Heft 1, 1969, Seite 13). Dadurch, daß der Differenzverstärker in der vorgesehenen Weise mit dem Darlington-Verstärker gekoppelt ist und die betreffenden Schaltungen stromsymmetrisch eingestellt sind, ergeben sich die angestrebten guten Symmetrieeigenschaften sowie die hohe Stabilität der Arbeitspunkte. Zugleich arbeitet der Verstärker bereits bei einer sehr geringen Betriebsspannung und läßt einen großen Bereich für den Speisegleichstrom zu.

Eine zweckmäßige weitere Ausgestaltung des Mikrofonverstärkers ergibt sich, wenn der Darlington-Verstärker mit Hilfe von zwei Transistoren aufgebaut ist, die eigene Kollektorwiderstände haben. Ein derartiger Darlington-Verstärker hat nämlich eine besonders hohe Aussteuerfähigkeit. Zweckmäßigerweise wird hierbei ein Ausgangstransistor mit einer niedrigen Sättigungsspannung benutzt. Außerdem ist es zweckmäßig, eine Referenzspannungsquelle zu benutzen, die eine besonders niedrige stabilisierte Referenzspannung liefert.

Die vorstehend angegebenen Effekte werden nun an einem Beispiel für einen Mikrofonverstärker näher erläutert, der eine besonders zweckmäßig ausgestaltete Referenzspannungsquelle hat. In dieser Figur ist die Verstärkerschaltung VS und die Referenzspannungsquelle RG gezeigt. Der Eingang der Verstärkerschaltung VS liegt bei den Klemmen E1 und E2. Der Ausgang liegt bei den Klemmen A3 und A4. Der akustisch-elektrische Wandler, insbesondere eine piezoelektrische Keramik, ist bei den Eingangsklemmen E1 und E2 angeschlossen. Die Betriebsspannung +/0 und damit auch der Speisegleichstrom werden über die Ausgangsklemmen A3 und A4 zugeführt. Dem Speisegleichstrom ist dann das Ausgangssignal überlagert. An die Eingangskleeme E1 ist nun noch die von der Referenzspannungsquelle RG gelieferte Referenzspannung angelegt. Mit ihrer Hilfe wird der Arbeitspunkt des Differenzverstärkers mit den Transistoren T13 und T14, der zur Verstärkerschaltung gehört, stabilisiert.

Zur Verstärkerschaltung VS gehören außer dem Differenzverstärker mit den Transistoren T13 und T14, mit den Emitterwiderständen R12 und R13 und mit den Kollektorwiderständen R8 und R9 noch die Transistorkoppelstufe mit den Transistoren T15 und T16, der zweistufige Zwischenverstärker mit den Transistoren T20 und T21 und der Darlington-Verstärker mit den Transistoren T23 und T24. Der Transistor T23 hat den Kollektorwiderstand R21 und der Transistor T24 hat den Kollektorwiderstand RL. Zwischen dem Ausgang und dem Eingang der Verstärkerschaltung ist das Gegenkopplungsnetzwerk mit den Widerständen R19, R18, R15, R14, R11, R17, R16 und R10 eingefügt. Der Arbeitspunkt der Ausgangstransistoren wird über den Spannungsteiler aus den Widerständen R19 und R18 und über die Widerstände R14 und R15 unter Mitwirkung der von der Referenzspannungsquelle RG gelieferten Referenzspannung eingestellt. Über die Widerstände R10 und R11 werden mit Hilfe der Referenzspannung die Arbeitspunkte des Differenzverstärkers mit den Transistoren T13 und T14 bestimmt. Die Spannungsverstärkung des Mikrofonverstärkers wird über die Widerstände R15, R16 und R17 und über den Widerstand R14 im Zuge des zugehörigen Gegenkopplungszweiges festgelegt.

Es sind nun hier noch drei Stromspiegelschaltungen vorgesehen, mit deren Hilfe die Koppelstufe, nämlich die symmetrisch geschaltete Transistorkoppelstufe mit den Transistoren T15 und T16 und der zweistufige Zwischenverstärker mit den Transistoren T20 und T21 sowie die Eingangsstufe mit den Transistoren T13 und T14 stromsymmetrisch eingestellt sind. Die Transistoren T15 und T16 der Transistorkoppelstufe gehören auch zu einer Stromspiegelschaltung mit den Transistoren T17 und T18. Dadurch und mit Hilfe der zusätzlichen Stromspiegelschaltung mit den Transistoren T25 und T26 und den Widerständen R24 und R25 sowie der weiteren Stromspiegelschaltung mit den Transistoren T9, T10, T11, T12 und T19 sind die Koppelstufe und die Eingangsstufe stromsymmetrisch eingestellt. Die zur Transistorkoppelstufe gehörenden Transistoren T15 und T16 sind untereinander gleich. Ihre Emitter sind mit den Kollektoren der Transistoren T13 und T14 des Differenzverstärkers einzeln verbunden. Die Kollektoren der Transistoren T15 und T16 sind an die beiden Stromzweige der bereits erwähnten Stromspiegelschaltung mit den Transistoren T25 und T26 angeschlossen. An einen der beiden Kollektoren ist dann der Zwischenverstärker mit den Transistoren T20 und T21 angeschlossen.

Auch die Hauptstromkreise der Transistoren T20 und T21 des Zwischenverstärkers sind über Stromzweige von Stromspiegelschaltungen geführt. Dazu gehört die bereits erwähnte Stromspiegelschaltung mit den Transistoren T17, T18 und T22 sowie den Widerständen R20 und R22, über deren Stromzweig mit dem Transistor T17 der Emitterkreis des Transistors T21 des Zwischenverstärkers geführt ist. Diese Stromspiegelschaltung hat noch einen zweiten Stromzweig mit dem Transistor T18, der in Reihe zu einem Stromzweig der weiteren Stromspiegelschaltung liegt, zu der die Transistoren T9, T10, T11, T12 und T19 gehören. Der Stromzweig mit dem Transistor T18 liegt in Reihe zu dem dazugehörigen Stromzweig mit dem Transistor T19. Über einen zweiten Stromzweig mit dem Transistor T12 der weiteren Stromspiegelschaltung ist der Emitterkreis des Transistors T20 des Zwischenverstärkers geführt. Diese weitere Stromspiegelschaltung hat noch einen zusätzlichen Stromzweig mit dem Transistor T11, über den der gemeinsame Emitterkreis des Differenzverstärkers mit den Transistoren T13 und T14 geführt ist. Mit Hilfe der bereits erwähnten Stromspiegelschaltungen sind die symmetrisch geschaltete Transistorkoppelstufe mit den Transistoren T15 und T16, der zweistufige Zwischenverstärker mit den Transistoren T20 und T21 und die Eingangsstufe mit den Transistoren T13 und T14 jeweils stromsymmetrisch eingestellt. Dadurch wird die besonders stabile Arbeitsweise der Verstärkerschaltung erzielt. Es zeigt sich auch, daß dadurch die Verstärkereigenschaften wenig von den Speisebedingungen der Schaltung abhängig sind. Wegen des sehr geringen Spannungsbedarfs der Schaltung und der übrigen günstigen Eigenschaften ergibt sich auch die sehr große Aussteuerfähigkeit der Verstärkerschaltung. Bei der Stabilisierung der Schaltung wirkt noch der Gegenkopplungskondensator C1 mit.

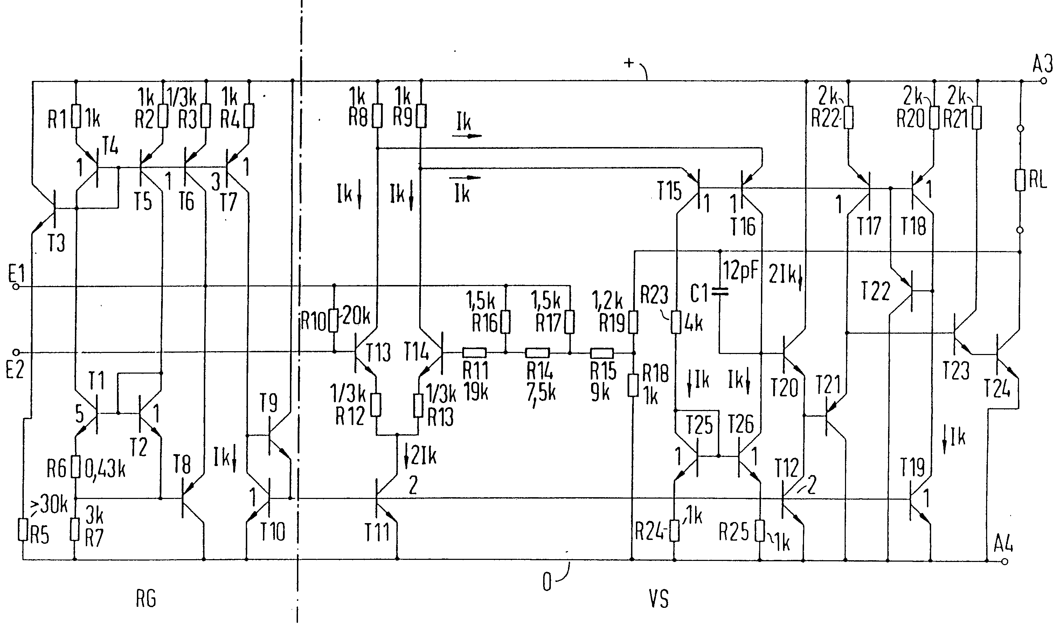

Bei den verschiedenen zur Schaltung gehörenden Widerständen ist auch jeweils die Ohmzahl angeschrieben. Anhand der für die Darstellung der Transistoren gewählten Symbole ist auch erkennbar, ob es sich jeweils um einen pnp-Transistor oder um einen npn-Transistor handelt. In der Figur sind schließlich noch mit « IK » bzw. mit « 2IK » bezeichnete Pfeile eingezeichnet, welche die richtung und die Größe der in den betreffenden Stromzweigen fließenden Ströme angeben. Diese Ströme ergeben sich vor allem dadurch, daß die beschriebenen Stromspiegelschaltungen vorgesehen sind. Dabei ist auch noch zu berücksichtigen, daß die Stärke der in den Stromzweigen von Stromspiegelschaltungen fließenden Ströme entsprechend der Größe der Emitterflächen der in diese Stromzweige eingeschleiften Transistoren gestuft sind. So fließt z.B. über den Transistor T11 der Strom 2IK, über den Transistor T12 ebenfalls der Strom 2IK und über den Transistor T19 der Strom IK. Die relative Größe der Emitterflächen dieser Transistoren ist dort noch durch jeweils angeschriebene Ziffern bzw. 2 angedeutet. Auch bei anderen Transistoren ist die Größe von Emitterflächen zum Teil durch angeschriebene Ziffern angedeutet, soweit dies für die Arbeitsweise der Schaltung von besonderer Bedeutung ist. Dies betrifft insbesondere Transistoren, die zur Referenzspannungsquelle RG gehören, wie die Transistoren T1, T2, T4, T5, T6 und T7.

Die Stromspiegelschaltung mit den Transistoren T9, T10, T11, T12 und T19 ist an die Ausgangsstufe mit den Transistoren T6 und T8 der Referenzspannungsquelle mittels des Transistors T7 und des Widerstandes R4 angekoppelt. Diese Ausgangsstufe besteht aus der Reihenschaltung dieser Transistoren T6 und T8 und des Widerstandes R3. Am Verbindungspunkt zwischen Kollektor und Emitter dieser in Reihe geschalteten Transistoren T6 und T8 wird die Referenzspannung für die damit belieferte Verstärkerschaltung VS abgenommen.

Bei der Referenzspannungsquelle selber steht die Referenzspannung an den miteinander verbundenen Basen der Transistoren T1 und T2 an, von denen der Transistor T2 als Diode geschaltet ist, während der andere Transistor T1 normal betrieben ist. In die Kollektorstromkreise der Transistoren T1 und T2 ist die Stromspiegelschaltung mit den Transistoren T4 und T5 eingeschleift sowie den Widerständen R1 und R2. Der bereits erwähnte und zur Ausgangsstufe gehörende Transistor T6 ist dort in Stromspiegelschaltung zusätzlich angeschlossen. Der damit in Reihe liegende Transistor T8 ist an Bezugspotential 0 gelegt. Seine Basis ist mit den Emitterwiderständen R6 und R7 der Transistoren T1 und T2 verbunden. Dadurch, daß die Referenzspannung an dem Abgriff der Reihenschaltung der Transistoren T6 und T8 abgenommen wird, wird eine Belastung des inneren Referenzschaltungspunktes der Referenzspannungsquelle vermieden, es wird also eine Belastung der miteinander verbundenen Basen der Transistoren T1 und T2 vermieden. Dies ist auch dann der Fall, wenn der Abgriff als Stromquelle bzw. Stromsenke für die Stabilisierung des Arbeitspunktes der Verstärkerschaltung VS ausgenutzt wird. Damit ist eine besonders große Konstanz der Referenzspannung sichergestellt. Die Höhe der Referenzspannung selber wird durch die am inneren Referenzspannungspunkt liegende Spannung bestimmt. Der Spannungsbedarf zum Erzeugen der Referenzspannung liegt hier sehr niedrig, er liegt nämlich nur um die Sättigungsspannung des Transistors T6 über der Referenzspannung, die am Emitter des Transistors T8 anliegt.

Die Referenzspannungsquelle RG ist noch durch die Anlaßschaltung aus der Reihenschaltung des Transistors T3 und seines Emitterwiderstandes R5 ergänzt. An diese Anlaßschaltung ist auch die Betriebsspannung +/0 angelegt. Die Basis des Transistors T3 ist mit dem Kollektor des Transistors T1 verbunden. Hierdurch ist sichergestellt, daß beim Anlegen der Betriebsspannung sich am inneren Referenzschaltungspunkt die vorgesehene Referenzspannung einstellt.

Bei der Referenzspannungsquelle RG ist die Fläche des Emitters des als Diode geschalteten Transistors T2 ein Bruchteil der Fläche des Emitters des anderen zugehörigen Transistors T1. Hierdurch und durch die weiteren vorgesehenen Schaltungsmaßnahmen ergibt sich eine Temperaturkompensation insofern, als dadurch die erzielte Referenzspannung weitgehend unabhängig von der Temperatur ist (siehe auch « Regelungstechnik », Heft 1, 1969, Seite 13 ; DE-B-19 440 28, Spalte 1). Bei dem in der Figur gezeigten Schaltungsbeispiel ist die Fläche des Emitters des Transistors T1 fünfmal so groß wie die Fläche des Emitters des Transistors T2. Dies ist dort auch durch die angeschriebenen Ziffern 5 und 1 angedeutet. Für die Temperaturkompensation ist auch das Verhältnis der Widerstandswerte der Emitterwiderstände R6 und R7 von Bedeutung.

Zur Stromspiegelschaltung mit den Transistoren T4 und T5 sowie T6 gehört noch der zusätzliche Transistor T7, der die Stromspiegelschaltung mit den Transistoren T8, T9, T11, T12 und T19 speist. Die zuletzt gennanten drei Transistoren sind in Stromkreise der mit der Referenzspannung belieferten Verstärkerschaltung VS eingeschleift. Die Transistoren T11, T12 und T19 sind bereits beschrieben worden. Durch diese Schaltungstechnik wird eine bestimmte Stromeinprägung für die Verstärkerschaltung erzielt, wozu Schaltmittel verwendet sind, die sich bequem an die zur Referenzspannungsquelle gehörenden Schaltmittel anfügen lassen.

Der vorstehend beschriebene Mikrofonverstärker ist auch derart schaltungstechnisch ausgestaltet, daß er sich bequem innerhalb einer integrierten Schaltung realisieren läßt. Seine vorteilhaften Eigenschaften bleiben dabei erhalten.

## Ansprüche

1. Zwischen seiner Eingangsstufe (T13, T14) und seiner Ausgangsstufe (T23, T24) gleichstromgekoppelter Mikrofonverstärker, insbesondere für Fernsprechanlagen, dessen Wechselstrom-Ausgangssignal dem Speisestrom überlagert ist und zu dem als Eingangsstufe für das entsprechende Wechselsignal ein Differenzverstärker mit zwei Transistoren (T13, T14) und mit Widerstandsstabilisierung im Emitterkreis, als Ausgangsstufe für das verstärkte Wechselsignal, also für das Wechselstrom-Ausgangssignal, ein als gesteuerte Spannungsquelle arbeitender Darlington-Verstärker (T23, T24), ein zwischen der Ausgangsstufe und der Eingangsstufe eingefügtes Spannungsgegenkopplungsnetzwerk (R10, R11, R14 bis R19) und eine Referenzspannungsquelle bzw. Referenzstromquelle (RG mit T7) zur Stabilisierung des Arbeitspunktes des Differenzverstärkers gehören, dadurch gekennzeichnet, daß der Differenzverstärker (T13, T14) das Wechselsignal über eine zwei Zweige aufweisende, symmetrisch geschaltete Transistorkoppelstufe (T15, T16) und über einen hochverstärkenden Zwischenverstärker (T20, T21) zum Darlington-Verstärker (T23, T24) weiterleitet, und daß zur Stabilisierung der arbeitpunkte der Eingangsstufe des Differenzverstärkers (T13, T14), der Transistorkoppelstufe (T15, T16) und des Zwischenverstärkers (T10, T21) mittels Stromspiegelschaltungen (T9 bis T12, T19 ; T15 bis T18 ; T25, T26) die Eingangsstufe des Differenzvorstärkers (T13, T14) und die Transistorkoppelstufe (T15, T16) stromsymmetrisch eingestellt sind, wobei eine der Stromspiegelschaltungen (T9 bis T12, T19) einen Stromzweig (T11) hat, über den der gemeinsame Emitterkreis der Eingangsstufe (T13, T14) geführt ist und wobei eine andere, erste Stromspiegelschaltung (T25, T26) zwei Stromzweige (T25, T26) hat, über die Zweige der Transistorkoppelstufe (T15, T16) geführt sind.

2. Mikrofonverstärker nach Anspruch 1, dadurch gekennzeichnet, daß die Transistorkoppelstufe (T15, T16) zwei gleiche Transistoren (T15, T16) enthält, deren Emitter mit den Kollektoren der Transistoren (T13, T14) des Differenzverstärkers (T13, T14) einzeln verbunden sind, daß die Kollektoren der beiden gleichen Transistoren (T15, T16) an die beiden Stromzweige der ersten Stromspiegelschaltung (T25, T26) angeschlossen sind und daß an den einen dieser beiden Kollektoren der Zwischenverstärker (T20, T21) angeschlossen sind.

3. Mikrofonverstärker nach Anspruch 2, dadurch gekennzeichnet, daß die Hauptstromkreise beider Transistoren (T20, T21) des Zwischenverstärkers (T20, T21) über Stromzweige (T17, T12) von Stromspiegelschaltungen geführt sind.

4. Mikrofonverstärker nach Anspruch 2 oder 3, dadurch gekennzeichnet, daß eine zweite Stromspiegelschaltung (T15, T16, T17, T18, T22) vorgesehen ist, die einen Stromzweig (T17) hat, über den der Emitterkreis des einen Transistors (T21) des Zwischenverstärkers geführt ist, und die einen weiteren Stromzweig (T18) hat, der in Reihe zu einem Stromzweig (T19) einer dritten Stromspiegelschaltung (T9, T10, T11, T12, T19) liegt, über deren zweiten Stromzweig (T12) der Emitterkreis des anderen Transistors (T20) des Zwischenverstärkers führt.

5. Mikrofonverstärker nach Anspruch 4, dadurch gekennzeichnet, daß die dritte Stromspiegelschaltung (T9, T10, T11, T12, T19) jenen weiteren Stromzweig (T11) hat, über den der gemeinsame Emitterkreis des Differenzverstärkers (T13, T14) geführt ist.

6. Mikrofonverstärker nach Anspruch 5 mit einer Referenzspannungsquelle, bei der die Referenzspannung an den miteinander verbundenen Basen zweier Transistoren ansteht, von denen der eine als Diode geschaltet ist, während der andere normal betrieben ist, und bei der eine Ausgangsstufe mit zwei Transistoren vorgesehen ist, die ohne Belastung des inneren Referenzschaltungspunktes als Stromquelle bzw. Stromsenke für die Stabilisierung des Arbeitspunktes des Differenzverstärkers wirkt, dadurch gekennzeichnet, daß an die Ausgangsstufe (T6, T8) mittels eines Transistors (T7) die dritte Stromspiegelschaltung (T9, T10, T11, T12, T19) angekoppelt ist.

7. Mikrofonverstärker nach einem der vorhergehenden Ansprüche, dadurch gekennzeichnet, daß die Stärke der in den Stromzweigen von Stromspiegelschaltungen fließenden Ströme entsprechend der Größe der Emitterflächen der in diese Stromzweige eingeschleiften Transistoren (z.b. T11, T12, T19) gestuft sind.

8. Mikrofonverstärker nach einem der vorhergehenden Ansprüche, dadurch gekennzeichnet, daß die beiden Transistoren (T23, T24) des Darlington-Verstärkers eigene Kollektorwiderstände (R21, RL) haben.

**Claims**

1. A microphone amplifier which is d.c. coupled between its input stage (T13, T14) and its output stage (T23, T24), in particular for telephone systems, whose a.c. output signal is superimposed upon the feed current and which comprises, by way of input stage for the corresponding alternating signal, a differential amplifier with two transistors (T13, T14) and with resistance stabilisation in the emitter circuit, and which comprises, by way of output stage for the amplified alternating signal, thus for the alternating current output signal, a Darlington amplifier (T23, T24) which operates as a controlled voltage source, a voltage negative feedback network (R10, R11, R14 to R19) which is interposed between the output stage and the input stage, and a reference voltage source of reference current source (R6 together with T7) which serves to stabilise the operating point of the differential amplifier, characterised in that the differential amplifier (T13, T14) forwards the alternating signal via a transistor coupling stage (T15, T16) which comprises two arms and which is symmetrically connected and via a high amplification intermediate amplifier (T20, T21) to the Darlington amplifier (T23, T24), and that in order to stabilise the operating points of the input stage of the differential amplifier (T13, T14), of the transistor coupling stage (T15, T16), and of the intermediate amplifier (T10, T21), by means of current reflector circuits (T9 to T12, T19 ; T15 to T18 ; T25, T26) the input stage of the differential amplifier (T13, T14) and the transistor coupling stage (T15, T16) are adjusted so as to be current. symmetrical, where one of the current reflector circuits (T9 to T12, T19) possesses a current arm (T11) via which extends the common emitter circuit of the input stage (T13, T14), and wherein another first current reflector circuit (T25, T26) possesses two current arms (T25, T26) via which extend the arms of the transistor coupling stage (T15, T16).

2. Microphone amplifier as claimed in claim 1, characterised in that the transistor coupling stage (T15, T16) contains two identical transistors (T15, T16), whose emitters are respectively connected to the collectors of the transistors (T13, T14) of the differential amplifier (T13, T14), that the collectors of the two identical transistors (T15, T16) are connected to the two current arms of the first current reflector circuit (T25, T26), and that the intermediate amplifier (T20, T21) is connected to one of these two collectors.

3. Microphone amplifier as claimed in claim 2, characterised in that the main circuits of the two transistors (T20, T21) of the intermediate amplifier (T20, T21) extend via the current arms (T17, T12) of current reflector circuits.

4. Microphone amplifier as claim 2 or 3, characterised in that a second current reflector circuit (T15, T16, T17, T18, T22) is provided which possesses a current arm (T17) via which extends the emitter circuit of one transistor (T21) of the intermediate amplifier, and which possesses a further current arm (T18) which is arranged in series with a current arm (T19) of a third current reflector circuit (T9, T10, T11, T12, T19) via whose second current arm (T12) extends the emitter circuit of the other transistor (T20) of the intermediate amplifier.

5. Microphone amplifier as claimed in claim 4, characterised in that the third current reflector circuit (T9, T10, T11, T12, T19) possesses that further current arm (T11) via which extends the common emitter circuit of the differential amplifier (T13, T14).

6. Microphone amplifier as claimed in claim 5 comprising a reference voltage source wherein the reference voltage occurs across the bases, which are connected to one another, of two transistors, one of which is connected as a diode, whereas the other is operated in normal fashion, and wherein an output stage comprising two transistors is provided which in the absence of load on the inner reference circuit point operates as current source/current sink for the stabilisation of the operating point of the differential amplifier, characterised in that the third current reflector circuit (T9, T10, T11, T12, T19) is connected to the output stage (T6, T8) by means of a transistor (T7).

7. Microphone amplifier as claimed in one of the preceding claims, characterised in that the magnitude of the currents flowing in the current arms of current reflector circuits is graded in accordance with the size of the emitter surfaces of the transistors (e.g. T11, T12, T19) which are looped into these current arms.

8. Microphone amplifier as claimed in one of the preceding claims, characterised in that the two transistors (T23, T24) of the Darlington circuit possess their own collector resistors (R21, RL).

## Revendications

1. Amplificateur de microphone à couplage en courant continu, disposé entre son étage d'entrée (T13, T14) et son étage de sortie (T23, T24), plus particulièrement pour des installations téléphoniques, dont le signal de sortie en courant alternatif est superposé au courant d'alimentation, et auquel appartiennent, comme étages d'entrée pour le signal alternatif correspondant, un amplificateur différentiel à deux transistors (T13, T14) et à stabilisation par résistances dans le circuit émetteur, et, comme étages de sortie pour le signal alternatif amplifié, donc pour le signal de sortie en courant alternatif, un amplificateur de Darlington (T23, T24) opérant comme source de tension commandée, un réseau de contre-réaction de tension (R10, R11, R14 à R19) disposé entre l'étage de sortie et l'étage d'entrée et une source de tension de référence ou une source de courant de référence (RG avec T7) pour stabiliser le point de fonctionnement de l'amplificateur différentiel, caractérisé par le fait que l'amplificateur différentiel (T13, T14) transmet le signal alternatif à l'amplificateur de Darlington (T23, T24) par l'intermédiaire d'un étage de couplage à transistors (T15, T16) qui présente un montage symétrique et possède deux branches et par l'intermédiaire d'un amplificateur intermédiaire (T20, T21) à forte amplification, et que pour la stabilisation des points de fonctionnement de l'étage d'entrée de l'amplificateur différentiel (T13, T14), de l'étage de couplage à transistors (T15, T16) et de l'amplificateur intermédiaire (T10, T21), l'étage d'entrée de l'amplificateur différentiel (T13, T14) et l'étage de couplage à transistors (T15, T16) sont ajustés symétriquement du point de vue du courant au moyen de circuits de courants conjugués (T9 à T12, T19 ; T15 à T18 ; T25, T26), l'un (T9 à T12, T19) des circuits de courants conjugués comportant une branche de courant (T11) par laquelle passe le circuit d'émetteur commun de l'étage d'entrée (T13, T14) et l'autre, le premier des circuits de courants conjugués (T25, T26) comportant deux branches de courant (T25, T26) par lesquelles passent les branches d'un étage de couplage à transistors (T15, T16).

2. Amplificateur de microphone selon la revendication 1, caractérisé par le fait que l'étage de couplage à transistors (T15, T16) comporte deux transistors identiques (T15, T16) dont les émetteurs sont reliés individuellement avec les collecteurs des transistors (T13, T14) de l'amplificateur différentiel (T13, T14), que les collecteurs des deux transistors identiques (T15, T16) sont reliés aux deux branches du premier circuit de courants conjugués (T25, T26) et qu'à l'un de ces deux collecteurs est relié l'amplificateur intermédiaire (T20, T21).

3. Amplificateur de microphone selon la revendication 2, caractérisé par le fait que les circuits des courants principaux des deux transistors (T20, T21) de l'amplificateur intermédiaire (T20, T21) passent par des branches (T17, T12) de circuits de courants conjugués.

4. Amplificateur de microphone selon la revendication 2 ou 3, caractérisé par le fait qu'il est prévu un second circuit de courants conjugués (T15, T16, T17, T18, T22) qui possède une branche de courant (T17) par lequel passe le circuit d'émetteur de l'un des transistors (T21) de l'amplificateur intermédiaire, et qui comporte une seconde branche de courant (T18) qui est montée en série avec une branche de courant (T19) d'un troisième circuit de courant conjugué (T19, T10, T11, T12, T19) dans la seconde branche du courant (T12) duquel se situe le circuit d'émetteur d'un autre transistor (T20) de l'amplificateur intermédiaire.

5. Amplificateur de microphone selon la revendication 4, caractérisé par le fait que le troisième circuit de courants conjugués (T9, T10, T11, T12, T19) possède ladite autre branche de courant (T11) dans laquelle se situe le circuit d'émetteur commun de l'amplificateur différentiel (T13, T14).

6. Amplificateur de microphone selon la revendication 5, comportant une source de tension de référence, dans laquelle la tension de référence est présente au niveau des bases, reliées entre elles, de transistors dont l'un est monté en diode, alors que l'autre est opéré normalement, et dans laquelle est prévu un étage de sortie à deux transistors, ledit étage de sortie agissant, sans charge du point de montage de référence intérieur, comme source de courant ou comme source de courant négative pour la stabilisation du point de fonctionnement de l'amplificateur différentiel, caractérisé par le fait qu'à l'étage de sortie (T6, T7) est accouplé, à l'aide d'un transistor (T7), le troisième circuit de courants conjugués (T9, T10, T11, T12, T19).

7. Amplificateur de microphone selon l'une des revendications précédentes, caractérisé par le fait que l'intensité des courants qui passent dans les branches des circuits de courants conjugués sont étagés en fonction de l'importance des surfaces d'émetteurs des transistors (par exemple T11, T12, T19) situés dans ces branches de courants.

8. Amplificateur de microphone selon l'une des revendications précédentes, caractérisé par le fait que les deux transistors (T23, T24) de l'amplificateur Darlington possèdent leur propre résistance de collecteur (R21, RL).

0 011 705